# EUROPÄISCHE PATENTANMELDUNG

(11) **EP 3 798 652 A1**
(43) Veröffentlichungstag der Anmeldung: **31.03.2021**
(21) Anmeldenummer: 19200431.5
(22) Anmeldetag: 30.09.2019
(51) Int. Cl.: G01R 31/34, G01R 31/12

(54) **VERFAHREN ZUM TESTEN EINES TEILENTLADUNGSMESSSYSTEMS FÜR EINE ELEKTRISCHE MASCHINE**

(71) Anmelder: Siemens Aktiengesellschaft, 80333 München (DE)
(72) Erfinder: Meyer, Martin, 90425 Nürnberg (DE); Zettner, Jürgen, 90587 Veitsbronn (DE)

(57) **Zusammenfassung**

Die Erfindung betrifft ein Verfahren zum Testen eines Teilentladungsmesssystems (4) für eine elektrische Maschine (2). Damit das Testverfahren während eines Betriebes einer elektrischen Maschine durchführbar ist, wird vorgeschlagen, dass das Teilentladungsmesssystem (4) eine erste Antenne (28a), eine zweite Antenne (28b) und einen der zweiten Antenne (28b) zugeordneten Empfangskanal (36) umfasst, wobei während des Betriebes der elektrischen Maschine (2) ein Niederspannungs-Testsignal (T) an die erste Antenne (28a) gesendet wird, wobei das Niederspannungs-Testsignal (T) von der ersten Antenne (28a) auf die zweite Antenne (28b) übertragen wird und wobei das auf die zweite Antenne (28b) übertragene Niederspannungs-Testsignal (T) vom zu testenden der zweiten Antenne (28b) zugeordneten Empfangskanal (36) empfangen und anschlie-βend ausgewertet wird.

## Beschreibung

Die Erfindung betrifft ein Verfahren zum Testen eines Teilentladungsmesssystems für eine elektrische Maschine.

Ferner betrifft die Erfindung eine Steuereinheit mit Mitteln zur Durchführung eines derartigen Verfahrens.

Darüber hinaus betrifft die Erfindung ein Computerprogramm zur Durchführung eines derartigen Verfahrens bei Ablauf in einer Steuereinheit.

Überdies betrifft die Erfindung ein Computerprogrammprodukt mit einem Computerprogramm.

Weiterhin betrifft die Erfindung ein Teilentladungsmesssystem zur Durchführung eines derartigen Verfahrens.

Zudem betrifft die Erfindung eine elektrische Maschine mit mindestens einem Teilentladungsmesssystem.

Ein derartiges Verfahren wird insbesondere in elektrischen Hochspannungsmaschinen, beispielsweise Hochspannungsmotoren, Hochspannungsgeneratoren und Hochspannungstransformatoren, verwendet, welche mit einer Spannung von mindestens 1 kV betreibbar sind.

Teilentladungen sind kurze lokale Entladungen, die sich als elektromagnetische Impulse in einer Maschine ausbreiten. Beispielsweise weisen Teilentladungspulse eine Dauer von unter 1 µs auf und sind auf einem hochfrequenten Trägersignal mit einer Frequenz im MHz-Bereich aufmoduliert. Ursache für derartige Teilentladungen sind beispielsweise Inhomogenitäten in einem Isolierstoff, wobei deren Auftreten unter Umständen langfristig zum Versagen der Isolierung und damit zu einem Ausfall der elektrischen Maschine führen. Deshalb werden elektrische Maschinen regelmäßig auf Teilentladung untersucht. Beispielsweise werden Teilentladungen an Versorgungsleitungen der elektrischen Maschine gemessen. Für die Erfassung von Teilentladungen gibt es eine Vielzahl von teilweise, beispielsweise nach DIN EN 60270, genormten Messverfahren.

Die Offenlegungsschrift US 2005/0012507 A1 beschreibt eine Teilentladungsüberwachungsvorrichtung für eine rotierende elektrische Maschine mit einer Teilentladungserfassungsschaltung, die jedes Signal, das von einem Teilentladungssensor in der rotierenden elektrischen Maschine ausgegeben wird, gleichzeitig in einem ersten Frequenzband und einem zweiten Frequenzband misst. Die Erfassungszeit für die Erfassung jedes Signals beinhaltet eine Spitzenhaltezeit und eine Totzeit, die nach der Spitzenhaltezeit liegt. Nach Ablauf der Totzeit wird ein nächstes Signal erkannt.

Die Offenlegungsschrift DE 196 47 686 A1 beschreibt eine Vorrichtung zur Erzeugung einer elektromagnetischen Testsignalfolge für eine Teilentladungsmesseinrichtung, insbesondere in einer Hochspannungsanlage, die eine Nutzwechselspannung führt.

Insbesondere bei einer Online-Messung, das heißt während des regulären Betriebes der elektrischen Maschine bei Anschluss an die Hochspannung, ist das Verhalten des Gesamtsystems, welches die elektrische Maschine und das Teilentladungsmesssystem umfasst, nicht immer genau vorhersehbar. Dies trifft insbesondere bei einer Nachrüstung des Teilentladungsmesssystems bei vorhandenen Maschinen zu. Fehlerquellen sind beispielsweise Anschlussfehler oder eine defekte oder fehlerhaft konfigurierte Auswerteelektronik.

Der Erfindung liegt die Aufgabe zugrunde, ein Verfahren zum Testen eines Teilentladungsmesssystems anzugeben, welches während eines Betriebes einer elektrischen Maschine durchführbar ist.

Die Aufgabe wird erfindungsgemäß gelöst durch ein Verfahren zum Testen eines Teilentladungsmesssystems für eine elektrische Maschine, wobei das Teilentladungsmesssystem eine erste Antenne, eine zweite Antenne und einen der zweiten Antenne zugeordneten Empfangskanal umfasst, wobei während des Betriebes der elektrischen Maschine ein Niederspannungs-Testsignal an die erste Antenne gesendet wird, wobei das Niederspannungs-Testsignal von der ersten Antenne auf die zweite Antenne übertragen wird und wobei das auf die zweite Antenne übertragene Niederspannungs-Testsignal vom zu testenden der zweiten Antenne zugeordneten Empfangskanal empfangen und anschließend ausgewertet wird.

Ferner wird die Aufgabe erfindungsgemäß durch eine Steuereinheit mit Mitteln zur Durchführung eines derartigen Verfahrens gelöst.

Darüber hinaus wird die Aufgabe erfindungsgemäß durch ein Computerprogramm zur Durchführung eines derartigen Verfahrens bei Ablauf in einer Steuereinheit gelöst.

Überdies wird die Aufgabe erfindungsgemäß durch ein Computerprogrammprodukt mit einem Computerprogramm gelöst.

Weiterhin wird die Aufgabe erfindungsgemäß durch ein Teilentladungsmesssystem zur Durchführung eines derartigen Verfahrens gelöst, welches eine erste Antenne, eine zumindest zweite Antenne, zumindest einen der zweiten Antenne zugeordneten Empfangskanal, einen Testsignalgenerator, welcher den Antennen zuschaltbar ist und eine Steuereinheit aufweist.

Zudem wird die Aufgabe erfindungsgemäß durch eine elektrische Maschine mit mindestens einem Teilentladungsmesssystem gelöst.

Die in Bezug auf das Testverfahren nachstehend angeführten Vorteile und bevorzugten Ausgestaltungen lassen sich sinngemäß auf die Steuereinheit, das Computerprogramm, das Computerprogrammprodukt, das Teilentladungsmesssystem und die elektrische Maschine übertragen.

Der Erfindung liegt die Überlegung zugrunde, ein Testverfahren für ein Teilentladungsmesssystem einer elektrischen Maschine anzugeben, das online, das heißt ohne manuelle Eingriffe und während eines regulären Betriebes der elektrischen Maschine, durchführbar ist. Eine derartige elektrische Maschine ist beispielsweise ein Motor, ein Generator oder ein Transformator. Insbesondere ist die elektrische Maschine mit einer Spannung von mindestens 1 kV betreibbar. Unter einem derartigen Testverfahren ist ein Funktionstest, ein Selbsttest oder ein Kalibrierverfahren zu verstehen. Um ein derartiges Online-Testsystem zu realisieren, werden Niederspannungs-Testsignale, insbesondere Niederspannungs-Testimpulse, statt bisher üblicher, insbesondere genormter, Hochspannungs-Testimpulse verwendet. Beispielsweise werden hochfrequente Niederspannungs-Testimpulse, welche insbesondere bereits empfangenen Teilentladungspulsen zumindest ähnlich sind, für das Testverfahren verwendet. Ein derartiger hochfrequenter Niederspannungs-Testimpuls weist beispielsweise eine Pulsdauer von unter 1 µs auf und ist auf einen hochfrequenten Träger, beispielsweise mit einer Frequenz von mindestens 5 MHz, moduliert. Alternativ ist der Niederspannungs-Testimpuls ein, insbesondere rechteckiges, Pulssignal mit einer Pulsdauer von unter 500 ns. Ein Niederspannungs-Testsignal weist beispielsweise eine Spitzenspannung von weniger als 20 V, insbesondere weniger als 10 V, auf. Das Teilentladungsmesssystem umfasst eine erste Antenne, eine zweite Antenne und einen der zweiten Antenne zugeordneten Empfangskanal, wobei zumindest die zweite Antenne und der der zweiten Antenne zugeordnete Empfangskanal auch für die eigentliche Teilentladungs-Messfunktion verwendet werden. Eine Antenne ist beispielsweise ein leerlaufender elektrischer Leiter. Das Niederspannungs-Testsignal wird über die erste Antenne an die zweite Antenne kontaktlos übertragen, wobei das auf die zweite Antenne übertragene Niederspannungs-Testsignal vom zu testenden Empfangskanal der zweiten Antenne empfangen und anschließend ausgewertet wird.

Durch den Empfangskanal wird das empfangene Niederspannungs-Testsignal aufbereitet, um es daraufhin zu digitalisieren und weiterzuverarbeiten. Eine, insbesondere digitale, Auswertung findet beispielsweise in einem programmierbaren Logikbaustein, beispielsweise in einem Mikrocontroller, statt. Optional findet eine Auswertung zumindest teilweise in einer Cloud statt. Eine Cloud ist eine zentrale IT-Infrastruktur, in der Speicherplatz, Rechenleistung und/oder Anwendungssoftware als Dienstleistung über das Internet zur Verfügung gestellt werden. Das Testverfahren umfasst insbesondere einen Test der Funktionalität des Empfängers und der, insbesondere digitalen, Auswertung des Teilentladungsmesssystems. Der Ablauf des Verfahrens wird mit einer Steuereinheit gesteuert, Mittel zur Durchführung des Verfahrens sind beispielsweise ein Programm, ein Prozessor und ein Speicher.

Bei einer bevorzugten Ausführungsform wird das Niederspannungs-Testsignal von der ersten Antenne auf die zweite Antenne durch elektromagnetisches Überkoppeln übertragen. Unter elektromagnetischem Überkoppeln ist eine Nahfeldkopplung von beispielsweise im Wesentlichen parallel verlaufend angeordneten Leitern zu verstehen. Eine derartige Übertragung ist, insbesondere bei für derartige Hochfrequenzkomponenten vergleichsweise niedrigen Frequenzen bis zu einigen hundert Megahertz, platzsparend und leicht zu realisieren.

In einer weiteren vorteilhaften Ausgestaltung wird zumindest eine Antenne als Messfühler, insbesondere als Temperaturfühler, verwendet. Der Temperaturfühler ist beispielsweise als RTD-Temperaturfühler ausgeführt, wobei die Antenne einen temperaturabhängigen Widerstand, der beispielsweise aus Platin hergestellt ist, und eine Zuleitung umfasst. Insbesondere wird in einem ersten Frequenzbereich ein Messsignal übertragen während das Teilentladungsmesssystem in einem zweiten Frequenzbereich arbeitet, wodurch Bauraum und Kosten eingespart werden.

Besonders vorteilhaft wird das Niederspannungs-Testsignal von einem Testsignalgenerator erzeugt. Mit Hilfe eines Testsignalgenerators sind beispielsweise Testimpulse generierbar, die in ihrer Form, Dauer und/oder Flankensteilheit variierbar sind, um gewünschte spektrale Anteile zu erzeugen. Der Testsignalgenerator ist als separates Bauteil oder in einem, beispielsweise vorhandenen, Mikroprozessor realisiert. Durch einen derartigen Testsignalgenerator wird eine hohe Flexibilität hinsichtlich der Form und der Frequenz des Niederspannungs-Testsignals erreicht.

Bei einer bevorzugten Ausgestaltung umfasst das Teilentladungsmesssystem einen der ersten Antenne zugeordneten Empfangskanal, wobei das Niederspannungs-Testsignal in den der ersten Antenne zugeordneten Empfangskanal des Teilentladungsmesssystems eingespeist wird. Beispielsweise wird das Niederspannungs-Testsignal über einen Richtkoppler oder einen Zirkulator eingespeist. Insbesondere werden die erste Antenne und der der ersten Antenne zugeordnete Empfangskanal im normalen Betrieb als Sensor verwendet, wodurch Bauraum und Kosten eingespart werden.

In einer bevorzugten Ausführungsform wird daraufhin ein weiteres Niederspannungs-Testsignal in den der zweiten Antenne zugeordneten Empfangskanal des Teilentladungsmesssystems eingespeist, wobei das Niederspannungs-Testsignal von der zweiten Antenne auf die erste Antenne übertragen wird und wobei das auf die erste Antenne übertragene Niederspannungs-Testsignal vom zu testenden der ersten Antenne zugeordneten Empfangskanal empfangen und anschließend ausgewertet wird. Beispielsweise werden in einem ersten Verfahrensschritt die zweite Antenne und der der zweiten Antenne zugeordnete Empfangskanal und in einem zweiten Verfahrensschritt die erste Antenne und der der ersten Antenne zugeordnete Empfangskanal getestet. Dies ist vorteilhaft, da keine dedizierte Antenne für Testzwecke erforderlich ist, wodurch Bauraum und Kosten eingespart werden.

Besonders vorteilhaft wird das Niederspannungs-Testsignal gleichzeitig auf mindestens eine weitere Antenne übertragen, welcher jeweils ein Empfangskanal zugeordnet ist. Eine Übertragung des Niederspannungs-Testsignals auf mindestens zwei Antennen ermöglicht ein gleichzeitiges Testen mehrerer Antennen und Empfangskanäle, was zu einer Zeitersparnis führt.

In einer weiteren vorteilhaften Ausgestaltung wird der jeweilige Empfangskanal vor dem Einspeisen des Niederspannungs-Testsignals in einen Sendemodus geschaltet. Für das Umschalten werden beispielsweise elektronische Schalter verwendet. Insbesondere derartige Schalter sind kostengünstig und platzsparend.

Bei einer weiteren vorteilhaften Ausführungsform verbleibt der mindestens eine weitere Empfangskanal in einem Empfangsmodus und/oder wird in einen Empfangsmodus geschaltet. Für das Umschalten werden beispielsweise elektronische Schalter verwendet. Insbesondere derartige Schalter sind kostengünstig und platzsparend.

Besonders vorteilhaft wird das Niederspannungs-Testsignal nach der Übertragung auf zumindest eine als Messfühler verwendete Antenne von einem niederfrequenten Messsignal, insbesondere mit Hilfe einer Frequenzweiche, getrennt. Eine Frequenzweiche ist eine, insbesondere passive, elektrische Schaltung, welche so ausgeführt ist, dass diese bezüglich eines ersten Ausgangs als Tiefpassfilter und bezüglich eines zweiten Ausgangs als Hochpassfilter wirkt. Beispielsweise wird ein empfangenes, insbesondere hochfrequentes, Niederspannungs-Testsignal über die Frequenzweiche von einem, insbesondere niederfrequenten, Messsignal, getrennt, wobei das, insbesondere niederfrequente, Messsignal separat weiterverarbeitet wird. Insbesondere ein derartiges Frequenzmultiplexverfahren ermöglicht eine gleichzeitige Analyse des Messsignals und des Niederspannungs-Testsignals.

Im Folgenden wird die Erfindung anhand der in den Figuren dargestellten Ausführungsbeispiele näher beschrieben und erläutert.

Es zeigen:
- FIG 1: einen Längsschnitt einer elektrischen Maschine mit einem Teilentladungsmesssystem,
- FIG 2: ein Blockschaltbild einer ersten Ausführungsform eines Teilentladungsmesssystems und
- FIG 3: ein Blockschaltbild einer zweiten Ausführungsform eines Teilentladungsmesssystems.

Bei den im Folgenden erläuterten Ausführungsbeispielen handelt es sich um bevorzugte Ausführungsformen der Erfindung. Bei den Ausführungsbeispielen stellen die beschriebenen Komponenten der einzelnen Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

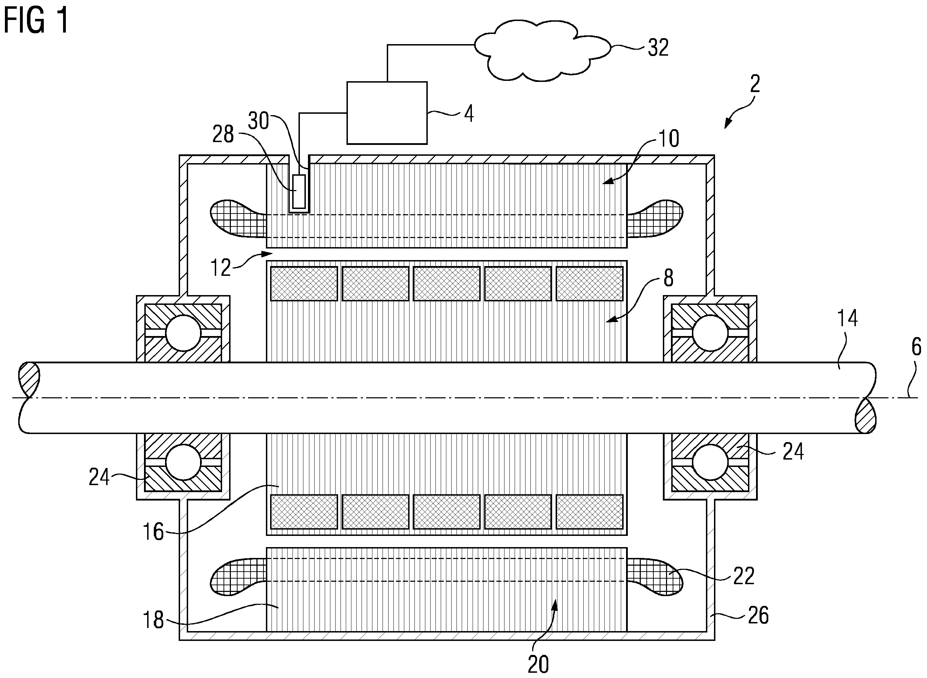

FIG 1 zeigt einen Längsschnitt einer elektrischen Maschine 2 mit einem Teilentladungsmesssystem 4. Die elektrische Maschine 2 ist exemplarisch als permanenterregte Synchronmaschine, welche als Motor und/oder Generator betreibbar ist, ausgeführt, wobei weitere Maschinentypen, wie beispielsweise als Motor und/oder Generator betreibbare Asynchronmaschinen und Transformatoren, ebenfalls zum Gegenstand der Erfindung gehören.

Die elektrische Maschine 2 weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12, der insbesondere als Luftspalt ausgeführt ist, befindet. Die Rotationsachse 6 definiert eine Axialrichtung und eine Radialrichtung. Der Rotor 8 umfasst eine Welle 14 und ein Rotorblechpaket 16. Der Stator 10 umfasst ein Statorblechpaket 18 mit Statorwicklungen 20, wobei das Statorblechpaket 18 aus einer Vielzahl von geschichteten Elektroblechen aufgebaut ist. Die Statorwicklungen 20 verlaufen in Axialrichtung durch das Statorblechpaket 18 und bilden an den axialen Enden des Statorblechpakets 18 Wickelköpfe 22 aus. Die Welle 14 des Rotors 8 ist über Lager 24 gelagert. Der Rotor 8 und der Stator 10 sind in einem geschlossenen Maschinengehäuse 26 untergebracht.

Das Teilentladungsmesssystem 4 ist mit mindestens zwei Antennen 28 verbunden, wobei aus Gründen der Übersichtlichkeit nur eine Antenne 28 dargestellt ist. Zumindest eine der Antennen 28 wird als Messfühler, insbesondere als Temperaturfühler verwendet. Der Temperaturfühler ist beispielsweise als RTD-Temperaturfühler ausgeführt, wobei die als Messfühler verwendete Antenne 28 einen temperaturabhängigen Widerstand, der beispielsweise aus Platin hergestellt ist, und eine Zuleitung umfasst. Beispielsweise wird zumindest durch die Zuleitung eine Antennenfunktionalität bereitgestellt. Zusätzlich oder alternativ ist zumindest eine Antenne 28 als leerlaufende Leitung ausgeführt. Die Antennen 28 sind beispielhaft in einem Kanal 30, welcher durch das Statorblechpaket 18 verläuft, im Bereich der Statorwicklungen 20 angeordnet, wobei die Anordnung des Teilentladungsmesssystems 4 mit den Antennen 28 und dem Kanal 30 in FIG 1 nur schematisch dargestellt ist. Die Antennen 28 sind derartig angeordnet, dass eine, insbesondere elektromagnetische, Kopplung zwischen den Antennen 28 herstellbar ist. Insbesondere wird die Kopplung zwischen den Antennen 28 zumindest teilweise über deren Zuleitungen hergestellt.

Darüber hinaus ist das Teilentladungsmesssystem 4 mit einer IT-Infrastruktur 32 verbunden. Eine IT-Infrastruktur 32 ist beispielsweise mindestens ein lokales Computersystem und/oder eine Cloud. Die IT-Infrastruktur 32 stellt Speicherplatz, Rechenleistung und/oder Anwendungssoftware bereit. In einer Cloud werden Speicherplatz, Rechenleistung und/oder Anwendungssoftware als Dienstleistung über das Internet zur Verfügung gestellt. Die digitale Datenübertragung an die IT-Infrastruktur 32 findet drahtlos, drahtgebunden oder optisch statt. Beispielsweise werden die Daten über Bluetooth oder WLAN übertragen.

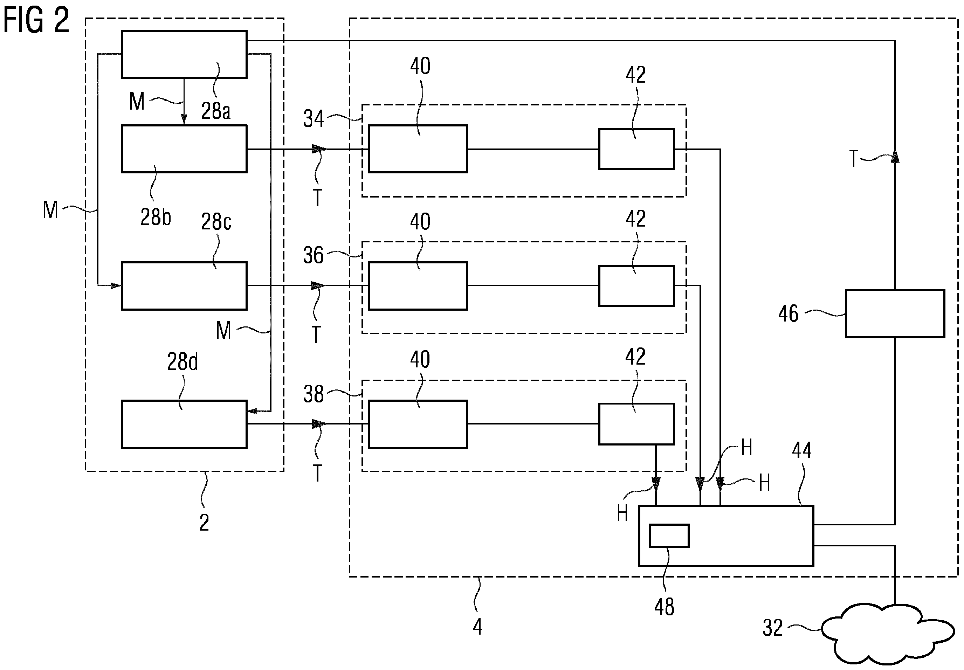

FIG 2 zeigt ein Blockschaltbild einer ersten Ausführungsform eines Teilentladungsmesssystems 4. Das Teilentladungsmesssystem 4 umfasst exemplarisch drei Empfangskanäle 34, 36, 38, die eingangsseitig jeweils mit einer im Bereich der elektrischen Maschine 2 angeordneten Antennen 28b, 28c, 28d verbunden sind. Ferner ist im Bereich der elektrischen Maschine 2 eine dedizierte erste Antenne 28a, welche nicht mit einem der Empfangskanäle 34, 36, 38 verbunden ist und folglich nicht zur Detektion von Teilentladungen verwendbar ist, derartig angeordnet, dass über die erste Antenne 28a eine, insbesondere elektromagnetische, Kopplung M mit der zweiten Antenne 28b, der dritten Antenne 28c und der vierten Antenne 28d herstellbar ist.

Die erste Antenne 28a ist beispielsweise als leerlaufende Leitung ausgeführt. Die weiteren Antennen 28b, 28c, 28d werden, wie in FIG 1 beschrieben, als Messfühler, insbesondere als Temperaturfühler verwendet. Die Empfangskanäle 34, 36, 38 umfassen jeweils eine Frequenzweiche 40 und eine Detektorschaltung 42. Ferner sind die Empfangskanäle 34, 36, 38 ausgangsseitig mit einem programmierbaren Logikbaustein 44, der beispielsweise einen Mikrocontroller aufweist, verbunden. Alternativ weist der programmierbare Logikbaustein 44 einen FPGA auf. Der programmierbare Logikbaustein 44 ist, wie in FIG 1 gezeigt und beschrieben, mit einer IT-Infrastruktur 32, insbesondere mit einer Cloud, verbunden.

Ein hochfrequentes Niederspannungs-Testsignal T, beispielsweise ein Niederspannungs-Testimpuls, wird mit Hilfe eines Testsignalgenerators 46 erzeugt und an die erste Antenne 28a übertragen. Der Niederspannungs-Testimpuls weist beispielsweise eine Pulsdauer von unter 1 µs auf und ist auf einen hochfrequenten Träger, beispielsweise mit einer Frequenz von mindestens 5 MHz, moduliert. Optional ist zumindest zweien, insbesondere allen, mit einem Empfangskanal 34, 36, 38 verbundenen Antennen 28b, 28c, 28d jeweils eine Antenne 28a zugewiesen, welche nicht mit einem der Empfangskanäle 34, 36, 38 verbunden ist, wobei das Niederspannungs-Testsignal T synchron an die zugewiesenen Antennen 28a übertragen wird. Die Übertragung des Niederspannungs-Testsignals T erfolgt über einen gemeinsamen Testsignalgenerator 46 oder alternativ über jeweils einen, insbesondere synchron angesteuerten, Testsignalgenerator 46.

Der Niederspannungs-Testimpuls weist eine Spitzenspannung von maximal 20 V, insbesondere maximal 10 V, auf und wird durch die, insbesondere elektromagnetische, Kopplung M an die mit den Empfangskanälen 34, 36, 38 verbundenen Antennen 28b, 28c, 28d übertragen. Die empfangenen hochfrequenten Niederspannungs-Testsignale T werden in den Empfangskanälen 34, 36, 38 über die Frequenzweiche 40 von einem niederfrequente Messsignal, welches aus Gründen der Übersichtlichkeit in FIG 2 nicht dargestellt ist, getrennt, wobei das niederfrequenten Messsignal separat weiterverarbeitet wird. Ferner wird mit Hilfe der Detektorschaltung 42 jeweils aus dem Niederspannungs-Testsignal T ein niederfrequentes Hüllkurvensignal H erzeugt, welches, insbesondere über einen Digital-Analog-Umsetzer im programmierbaren Logikbaustein 44, digitalisiert und anschließend weiterverarbeitet wird. Für das Testverfahren wird die zu testende Empfangselektronik des Teilentladungsmesssystems 4 verwendet. Die Digitalisierung ermöglicht eine rechnerbasierte Weiterverarbeitung der Informationen in einem übergeordneten System, beispielsweise in einer Cloud. Durch eine Steuereinheit 48, welche exemplarisch dem programmierbaren Logikbaustein 44 zugewiesen ist, wird der Verfahrensablauf gesteuert. Optional ist zwischen Testsignalgenerator 46 und der ersten Antenne 28a eine weitere Frequenzweiche 40 angeordnet, um die ersten Antenne 28a, wie in FIG 1 beschrieben, als Messfühler, insbesondere als Temperaturfühler, zu verwenden. Die weitere Ausführung des Teilentladungsmesssystems 4 in FIG 2 entspricht der Ausführung in FIG 1.

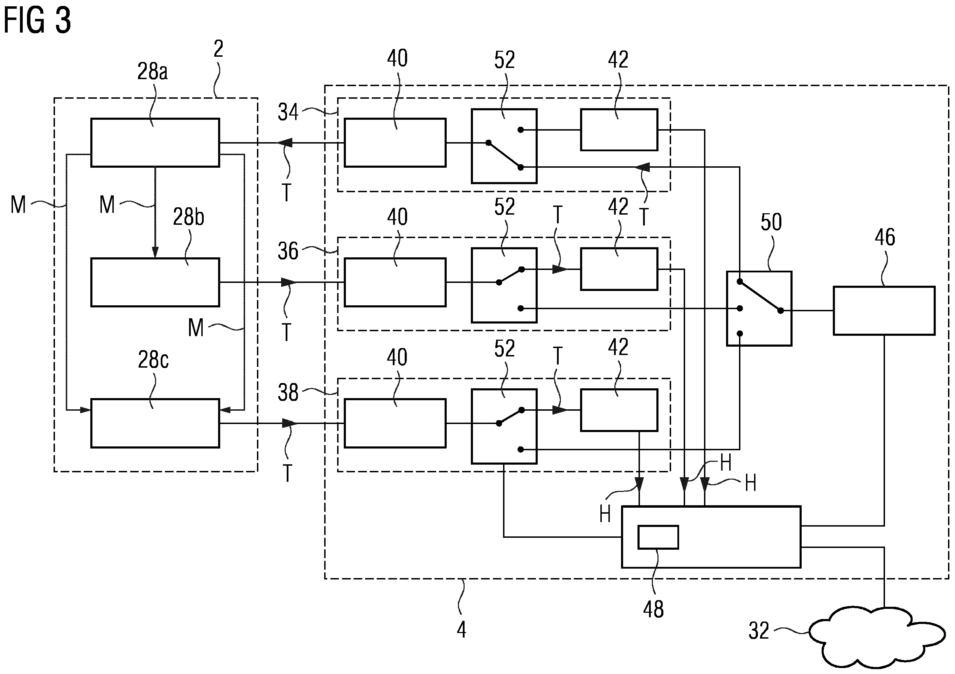

FIG 3 zeigt ein Blockschaltbild einer zweiten Ausführungsform eines Teilentladungsmesssystems 4. Der Testsignalgenerator 46 ist über einen Testsignal-Schalter 50 mit den Empfangskanälen 34, 36, 38 verbunden, wobei das hochfrequente Niederspannungs-Testsignal T je nach Zustand des Testsignal-Schalters 50 an einen der Empfangskanäle 34, 36, 38 übertragen wird. Die Empfangskanäle 34, 36, 38 weisen jeweils einen Sende- und Empfangsschalter 52 auf, welcher in einem Testmodus des Teilentladungsmesssystems 4 einen der Empfangskanäle 34, 36, 38 vor dem Einspeisen des Niederspannungs-Testsignals T in einen Sendemodus versetzt. Die übrigen Empfangskanäle 34, 36, 38 bleiben in einem Empfangsmodus oder werden in einen Empfangsmodus geschaltet. Beispielhaft befindet sich in FIG 3 der erste Empfangskanal 34 im Sendemodus, während sich der zweite Empfangskanal 36 und der dritte Empfangskanal 38 im Empfangsmodus befinden. Im Sendemodus des ersten Empfangskanals 34 ist die erste Antenne 28a mit dem Testsignalgenerator 46 verbunden, während die Detektorschaltung 42 des ersten Empfangskanals 34, beispielsweise durch einen eingangsseitigen Leerlauf, kein Signal empfangen kann und somit deaktiviert ist. Im Empfangsmodus sind die übrigen Empfangskanäle 34, 36, 38 durch eine Verbindung der jeweiligen Frequenzweiche 40 mit der zugehörigen Detektorschaltung 42 in der Lage, ein Testsignal T zu empfangen. Der Testsignal-Schalter 50 und die Sende- und Empfangsschalter 52 sind als elektronische Schalter ausgeführt und werden, insbesondere digital, über den programmierbaren Logikbaustein 44 angesteuert. Alternativ wird das Niederspannungs-Testsignal T über Richtkoppler oder Zirkulatoren eingespeist.

Zum Testen wird das Niederspannungs-Testsignal T, wie in FIG 2 dargestellt, in den ersten Empfangskanal 34 eingespeist, wobei das Niederspannungs-Testsignal T von der ersten Antenne 28a auf die zweite Antenne 28b und die dritte Antenne 28c übertragen wird und wobei das auf die zweite Antenne 28b und die dritte Antenne 28c übertragene Testsignal T von den zu testenden Empfangskanälen 36, 38 des Teilentladungsmesssystems 4 empfangen und anschließend im programmierbaren Logikbaustein 44 ausgewertet wird. Die Übertragung erfolgt beispielsweise durch elektromagnetisches Überkoppeln.

Daraufhin wird der zweite Empfangskanal 36 durch Umschalten des Testsignal-Schalters 50 und der Sende- und Empfangsschalter 52 des ersten Empfangskanals 34 und des zweiten Empfangskanals 36 in den Sendemodus versetzt, während der erste Empfangskanal 34 in den Empfangsmodus versetzt wird und der dritte Empfangskanal 38 im Empfangsmodus bleibt. Daraufhin wird ein weiteres Niederspannungs-Testsignal T in den zweiten Empfangskanal 36 des Teilentladungsmesssystems 4 eingespeist, wobei das weitere Niederspannungs-Testsignal T von der zweiten Antenne 28b auf die erste Antenne 28a und die dritte Antenne 28c übertragen wird und wobei das auf die erste Antenne 28a und die dritte Antenne 28c übertragene weitere Testsignal T von den zu testenden Empfangskanälen 34, 38 des Teilentladungsmesssystems 4 empfangen und anschließend im programmierbaren Logikbaustein 44 ausgewertet wird. Die Übertragung erfolgt beispielsweise durch elektromagnetisches Überkoppeln.

Daraufhin wird das Testverfahren analog mit der dritten Antenne 28c als Sendeantenne wiederholt, wobei der dritte Empfangskanal 38 in den Sendemodus versetzt wird und der erste Empfangskanal 34 und der zweite Empfangskanal 36 in den Empfangsmodus versetzt werden. Mit unterschiedlichen Testimpulsen und Einspeisungen ist beispielsweise eine Überkopplung zwischen den einzelnen Antennen 28a, 28b, 28c, 28d genauer beschreibbar, beispielsweise in einer Lage zueinander oder auch im Frequenzbereich. Insbesondere bei einer Nachrüstung der elektrischen Maschine 2 mit dem Teilentladungsmesssystem 4 ist häufig nicht die genaue Lage der Antennen 28a, 28b, 28c, 28d in der elektrischen Maschine 2 bekannt. Wünschenswert für die Teilentladungsmessung ist eine möglichst gleichmäßige Verteilung der verwendeten Antennen 28a, 28b, 28c, 28d über die gesamte Wicklung. Beispielsweise deutet ein sehr starkes Überkoppeln auf eine benachbarte Lage hin, so dass beispielsweise an der Position nur eine Antenne 28a, 28b, 28c, 28d für die Teilentladungsmessung genutzt werden muss, was mit entsprechend geringeren Kosten verbunden ist.

Idealerweise wird das Testverfahren bei einem Phasenwinkel durchgeführt, bei dem eine Wahrscheinlichkeit für eine Teilentladung gering ist. Eine geringere Wahrscheinlichkeit für eine Teilentladung besteht beispielsweise nach dem Erreichen der maximalen Spannung der jeweiligen Phase. Ein Phasenwinkel wird insbesondere mittels der vorhandenen Erfassungselektronik des Teilentladungsmesssystems 4 ermittelt. Alternativ wird der Phasenwinkel über externe Elektronik ermittelt und über eine Schnittstelle zugeführt. Die weitere Ausführung des Teilentladungsmesssystems 4 in FIG 3 entspricht der Ausführung in FIG 2.

Zusammenfassend betrifft die Erfindung ein Verfahren zum Testen eines Teilentladungsmesssystems 4 für eine elektrische Maschine 2. Damit das Testverfahren während eines Betriebes einer elektrischen Maschine durchführbar ist, wird vorgeschlagen, dass das Teilentladungsmesssystem 4 eine erste Antenne 28a, eine zweite Antenne 28b und einen der zweiten Antenne 28b zugeordneten Empfangskanal 36 umfasst, wobei während des Betriebes der elektrischen Maschine 2 ein Niederspannungs-Testsignal T an die erste Antenne 28a gesendet wird, wobei das Niederspannungs-Testsignal T von der ersten Antenne 28a auf die zweite Antenne 28b übertragen wird und wobei das auf die zweite Antenne 28b übertragene Niederspannungs-Testsignal T vom zu testenden der zweiten Antenne 28b zugeordneten Empfangskanal 36 empfangen und anschließend ausgewertet wird.

## Patentansprüche

1. Verfahren zum Testen eines Teilentladungsmesssystems (4) für eine elektrische Maschine (2),
wobei das Teilentladungsmesssystem (4) eine erste Antenne (28a), eine zweite Antenne (28b) und einen der zweiten Antenne (28b) zugeordneten Empfangskanal (36) umfasst,
wobei während des Betriebes der elektrischen Maschine (2) ein Niederspannungs-Testsignal (T) an die erste Antenne (28a) gesendet wird,
wobei das Niederspannungs-Testsignal (T) von der ersten Antenne (28a) auf die zweite Antenne (28b) übertragen wird und wobei das auf die zweite Antenne (28b) übertragene Niederspannungs-Testsignal (T) vom zu testenden der zweiten Antenne (28b) zugeordneten Empfangskanal (36) empfangen und anschließend ausgewertet wird.

2. Verfahren nach Anspruch 1,
wobei das Niederspannungs-Testsignal (T) von der ersten Antenne (28a) auf die zweite Antenne (28b) durch elektromagnetisches Überkoppeln übertragen wird.

3. Verfahren nach einem der Ansprüche 1 oder 2,
wobei zumindest eine Antenne (28a, 28b, 28c, 28d) als Messfühler, insbesondere als Temperaturfühler, verwendet wird.

4. Verfahren nach einem der vorherigen Ansprüche,
wobei das Niederspannungs-Testsignal (T) von einem Testsignalgenerator (46) erzeugt wird.

5. Verfahren nach einem der vorherigen Ansprüche,
wobei das Teilentladungsmesssystem (4) einen der ersten Antenne (28a) zugeordneten Empfangskanal (34) umfasst,
wobei das Niederspannungs-Testsignal (T) in den der ersten Antenne (28a) zugeordneten Empfangskanal (34) des Teilentladungsmesssystems (4) eingespeist wird.

6. Verfahren nach Anspruch 5,
wobei daraufhin ein weiteres Niederspannungs-Testsignal (T) in den der zweiten Antenne (28b) zugeordneten Empfangskanal (36) des Teilentladungsmesssystems (4) eingespeist wird, wobei das Niederspannungs-Testsignal (T) von der zweiten Antenne (28b) auf die erste Antenne (28a) übertragen wird und wobei das auf die erste Antenne (28a) übertragene Niederspannungs-Testsignal (T) vom zu testenden der ersten Antenne (28a) zugeordneten Empfangskanal (34) empfangen und anschließend ausgewertet wird.

7. Verfahren nach einem der vorherigen Ansprüche,
wobei das Niederspannungs-Testsignal (T) gleichzeitig auf mindestens eine weitere Antenne (28a, 28b, 28c, 28d) übertragen wird, welcher jeweils ein Empfangskanal (34, 36, 38) zugeordnet ist.

8. Verfahren nach einem der Ansprüche 4 bis 7,
wobei der jeweilige Empfangskanal (34, 36, 38) vor dem Einspeisen des Niederspannungs-Testsignals in einen Sendemodus geschaltet wird.

9. Verfahren nach Anspruch 8,
wobei der mindestens eine weitere Empfangskanal (34, 36, 38) in einen Empfangsmodus verbleibt und/oder geschaltet wird.

10. Verfahren nach Anspruch 3,
wobei das Niederspannungs-Testsignal (T) nach der Übertragung auf zumindest eine als Messfühler verwendete Antenne (28a, 28b, 28c, 28d) von einem niederfrequenten Messsignal, insbesondere mit Hilfe einer Frequenzweiche (40), getrennt wird.

11. Steuereinheit (48) mit Mitteln zur Durchführung eines Verfahrens nach einem der Ansprüche 1 bis 10.

12. Computerprogramm zur Durchführung eines Verfahrens nach einem der Ansprüche 1 bis 10 bei Ablauf in einer Steuereinheit (48) nach Anspruch 11.

13. Computerprogrammprodukt mit einem Computerprogramm nach Anspruch 12.

14. Teilentladungsmesssystem (4) zur Durchführung eines Verfahrens nach einem der Ansprüche 1 bis 10,
welches eine erste Antenne (28a), zumindest eine zweite Antenne (28b), zumindest einen der zweiten Antenne (28b) zugeordneten Empfangskanal (36), einen Testsignalgenerator (46), welcher den Antennen (28a, 28b) zuschaltbar ist und eine Steuereinheit (48) nach Anspruch 11 aufweist.

15. Teilentladungsmesssystem (4) nach Anspruch 14,
wobei der Testsignalgenerator (46) über elektronische Schalter (50, 52) zuschaltbar ist.

16. Teilentladungsmesssystem (4) nach einem der Ansprüche 14 oder 15,
wobei zumindest eine Antenne (28a, 28b, 28c, 28d) einen Messfühler, insbesondere einen Temperaturfühler, aufweist.

17. Elektrische Maschine (2) mit mindestens einem Teilentladungsmesssystem (4) nach einem der Ansprüche 14 bis 16.
